(19) Europäisches Patentamt
European Patent Office
Office européen des brevets

(11) EP 4 692 927 A1

(12) EUROPEAN PATENT APPLICATION
published in accordance with Art. 153(4) EPC

(43) Date of publication:
11.02.2026 Bulletin 2026/07

(51) International Patent Classification (IPC):
G03F 1/62 (2012.01)

(21) Application number: 24780218.4

(22) Date of filing: 25.03.2024

(52) Cooperative Patent Classification (CPC):
G03F 1/62

(86) International application number:
PCT/JP2024/011768

(87) International publication number:
WO 2024/204102 (03.10.2024 Gazette 2024/40)

(84) Designated Contracting States:
AL AT BE BG CH CY CZ DE DK EE ES FI FR GB
GR HR HU IE IS IT LI LT LU LV MC ME MK MT NL
NO PL PT RO RS SE SI SK SM TR
Designated Extension States:
BA
Designated Validation States:
GE KH MA MD TN

(30) Priority: 28.03.2023 JP 2023051837

(71) Applicant: LINTEC CORPORATION
Itabashi-ku
Tokyo 173-0001 (JP)

(72) Inventors:
• KUBO, Shuhei
Tokyo 173-0001 (JP)
• KAWAHARA, Jun
Tokyo 173-0001 (JP)
• ICHIKAWA, Isao
Tokyo 173-0001 (JP)

(74) Representative: Gille Hrabal
Partnerschaftsgesellschaft mbB
Patentanwälte
Brucknerstraße 20
40593 Düsseldorf (DE)

(54) PELLICLE FILM AND PELLICLE

(57) A pellicle film (10) has a porous structure. The pellicle film (10) includes carbon nanotubes. The coefficient of variation of pore diameters of pores is 0.7 or less, and the coefficient of variation of nearest-neighbor centroid-to-centroid distances between the pores is 0.6 or less, the coefficients of variation being measured at a surface of the porous structure.

FIG.1

**Description**

TECHNICAL FIELD

The present invention relates to a pellicle film and a pellicle.

BACKGROUND ART

In a process of manufacturing a semiconductor device or the like, for example, a photoresist is applied to a substrate such as a semiconductor wafer, the substrate coated with the photoresist is irradiated with light using a photomask, and the photoresist is removed, whereby a desired circuit pattern is formed on the substrate.

If light is applied in a state where foreign matter adheres to the photomask, the adhering foreign matter may adversely affect the circuit pattern formed on the substrate. For this reason, to inhibit adhesion of foreign matter to the photomask, a pellicle including a pellicle film for capturing foreign matter is occasionally used. The pellicle is disposed above the photomask at a distance such that the pellicle film is not in contact with the photomask.

In recent years, use of extreme ultra violet (EUV) has been studied in order to form a finer circuit pattern. EUV refers to light with a wavelength in a range from 1 nm to 100 nm. For example, specifically, a light beam with a wavelength of about 13.5 nm $\pm$ 0.3 nm is being used as EUV. When EUV is applied to a pellicle film, the EUV passes through the pellicle film, but the applied EUV is partially absorbed by the pellicle film. The light energy of the absorbed EUV is converted into thermal energy, whereby the temperature of the pellicle film is increased. Thus, the pellicle film is required to have, for example, EUV transmissivity, heat resistance, and durability.

In a pellicle used in a step of forming a circuit pattern using EUV, carbon nanotubes have been studied as one of the materials used for a pellicle film included in the pellicle.

For example, Patent Literature 1 discloses a pellicle film that includes, at least on its surface layer side, carbon nanotubes having a silicon carbide layer in which at least some carbon atoms are replaced with silicon atoms.

CITATION LIST

PATENT LITERATURE(S)

Patent Literature 1: International Publication No. 2021-172104

SUMMARY OF THE INVENTION

PROBLEM(S) TO BE SOLVED BY THE INVENTION

The pellicle film including carbon nanotubes disclosed in Patent Literature 1 is described as having high strength and high EUV transmissivity. However, there is no mention of the pellicle film disclosed in Patent Literature 1 regarding variation in pore characteristics in a surface of the pellicle film. Variation in pore characteristics tends to affect the strength and EUV transmissivity of pellicle films, and further improvements in pellicle films have been demanded.

An object of the invention is to provide a pellicle film including carbon nanotubes, the pellicle film having improved strength and showing less variation in EUV transmissivity, and a pellicle including the pellicle film.

MEANS FOR SOLVING THE PROBLEM(S)

[1] A pellicle film having a porous structure, in which the pellicle film includes carbon nanotubes, and a coefficient of variation of pore diameters of pores is 0.7 or less, and a coefficient of variation of nearest-neighbor centroid-to-centroid distances between the pores is 0.6 or less, the coefficients of variation being measured at a surface of the porous structure.

[2] The pellicle film according to [1], in which the coefficient of variation of pore diameters is in a range from 0.4 to 0.7.

[3] The pellicle film according to [1] or [2], in which the coefficient of variation of nearest-neighbor centroid-to-centroid distances is in a range from 0.2 to 0.5.

[4] The pellicle film according to any one of [1] to [3], in which the carbon nanotubes have a length in a range from 0.1 $\mu$m to 1000 $\mu$m.

[5] The pellicle film according to any one of [1] to [4], in which the carbon nanotubes have a cross-sectional diameter in a range from 0.2 nm to 50 nm.

[6] The pellicle film according to any one of [1] to [5], in which an average of the pore diameters is in a range from 20 nm to 60 nm.

[7] The pellicle film according to any one of [1] to [6], in which the pellicle film is a porous structural body formed by deposition of the carbon nanotubes.

[8] The pellicle film according to any one of [1] to [7], in which the pellicle film has a self-standing property.

[9] A pellicle including: the pellicle film according to any one of [1] to [8]; and a support that has a frame and an opening surrounded by the frame and that supports the pellicle film.

According to an aspect of the invention, a pellicle film including carbon nanotubes, the pellicle film having improved strength and showing less variation in EUV transmissivity, and a pellicle including the pellicle film can be provided.

BRIEF DESCRIPTION OF DRAWINGS

Fig. 1 is a plan view schematically illustrating an example of a pellicle according to an exemplary embodiment.

Fig. 2 is a sectional view taken along line II-II in Fig. 1.

Fig. 3A is a plan view schematically illustrating a pellicle for strength evaluation of a pellicle film.

Fig. 3B is a side view schematically illustrating the pellicle for strength evaluation of a pellicle film.

Fig. 4 is an explanatory view schematically illustrating strength evaluation of a pellicle film.

DESCRIPTION OF EMBODIMENTS

Pellicle Film

A pellicle film according to an exemplary embodiment has a porous structure. The pellicle film includes carbon nanotubes, the coefficient of variation of pore diameters of pores is 0.7 or less, and the coefficient of variation of nearest-neighbor centroid-to-centroid distances between the pores is 0.6 or less, the coefficients of variation being measured at a surface of the porous structure.

Due to the above configuration, the pellicle film according to the exemplary embodiment is considered to have pores in a nearly uniform state. Therefore, the pellicle film is considered to show less variation in strength of the pellicle film and show less in-plane variation in transmitted light transmitted through the pellicle film. As a result, the pellicle film according to the exemplary embodiment is considered to have improved strength and show less variation in EUV transmissivity.

The means for adjustment to a pellicle film in which the coefficient of variation of pore diameters of pores is 0.7 or less, and the coefficient of variation of nearest-neighbor centroid-to-centroid distances between the pores is 0.6 or less, the coefficients of variation being measured at a surface of the porous structure, is not particularly limited. One example of the means is adjusting, in an example of a preferred method for producing a pellicle film described later, the amount of carbon nanotubes included in the pellicle film (e.g., the amount of carbon nanotubes contained in a carbon nanotube film product which is an intermediate product in forming the pellicle film, or the amount of carbon nanotubes in a carbon nanotube dispersion in forming the carbon nanotube film product) and the intensity in dispersing the carbon nanotubes.

The carbon nanotubes included in the pellicle film according to the exemplary embodiment are not particularly limited and are preferably at least one selected from the group consisting of multi-walled carbon nanotubes (MWCNT), few-walled carbon nanotubes (FWCNT), double-walled carbon nanotubes (DWCNT), and single-walled carbon nanotube (SWCNTS).

The carbon nanotubes are obtained by, for example, a known production method such as an arc discharge method, a laser ablation method, or chemical vapor deposition.

For example, the length of the carbon nanotubes is preferably in a range from 0.1 $\mu$m to 1000 $\mu$m.

The length of the carbon nanotubes is more preferably 0.5 $\mu$m or more, still more preferably 1 $\mu$m or more.

The length of the carbon nanotubes is more preferably 600 $\mu$m or less, still more preferably 400 $\mu$m or less.

The cross-sectional diameter of the carbon nanotubes is preferably in a range from 0.2 nm to 50 nm.

The cross-sectional diameter of the carbon nanotubes is more preferably 0.5 nm or more, still more preferably 1 nm or more.

The cross-sectional diameter of the carbon nanotubes is more preferably 30 nm or less, still more preferably 20 nm or less.

Herein, a cross-sectional diameter may be referred to simply as a diameter.

In the pellicle film according to the exemplary embodiment, the coefficient of variation of pore diameters of pores measured at a surface of the porous structure is 0.7 or less. For the pellicle film to have further improved strength and show even less variation in EUV transmissivity, the coefficient of variation of pore diameters is preferably 0.68 or less, more preferably 0.67 or less.

The lower limit of the coefficient of variation of pore diameters is not particularly limited, and may be, for example, 0.40 or more, or may be 0.42 or more.

Herein, a pore diameter means a diameter of an imaginary circle having the same area as the area of a pore (i.e., an equivalent circle diameter). The coefficient of variation ($CV_1$) of pore diameters can be calculated by calculating the average ($D_1$ [unit: nm]) and the standard deviation ($\sigma_1$ [unit: nm]) of the pore diameters and using the following numerical formula (Numerical Formula 1).

$$\text{Coefficient of variation } CV_1 \text{ of pore diameters} = \sigma_1/D_1 \dots \text{(Numerical Formula 1)}$$

In the pellicle film according to the exemplary embodiment, the coefficient of variation of nearest-neighbor centroid-to-centroid distances between pores measured at a surface of the porous structure is 0.6 or less. For the pellicle film to have further improved strength and show even less variation in EUV transmissivity, the coefficient of variation of nearest-neighbor centroid-to-centroid distances is preferably 0.5 or less, more preferably 0.45 or less, and still more preferably 0.43 or less.

The lower limit of the coefficient of variation of nearest-neighbor centroid-to-centroid distances is not particularly limited, and may be, for example, 0.2 or more, or may be 0.25 or more.

Herein, a nearest-neighbor centroid-to-centroid distance between pores is the distance between the centroid of one pore and the centroid of a pore most closely adjacent to the one pore. That is, it means the distance from the centroid of one pore to the centroid of another pore, the pores being adjacent to each other. The coefficient of variation ($CV_2$) of nearest-neighbor centroid-to-centroid distances between pores can be calculated by calculating the average ($D_2$ [unit: nm]) and the standard deviation ($\sigma_2$ [unit: nm]) of the nearest-neighbor centroid-to-centroid distances between pores and using the following numerical formula (Numerical Formula 2).

Coefficient of variation $CV_2$ of nearest-neighbor centroid-to-centroid distances between pores = $\sigma_2/D_2$     (Numerical Formula 2)

In the pellicle film according to the exemplary embodiment, for example, the coefficient of variation of pore diameters of pores measured at a surface of the porous structure may be in a range from 0.4 to 0.7, and the coefficient of variation of nearest-neighbor centroid-to-centroid distances between the pores may be in a range from 0.2 to 0.6.

For the pellicle film to have further improved strength and show even less variation in EUV transmissivity, the average of pore diameters of pores measured at a surface of the porous structure of the pellicle film may be, for example, in a range from 20 nm to 60 nm. The average of pore diameters may be 25 nm or more, or may be 30 nm or more. The average of pore diameters may be 55 nm or less, or may be 50 nm or less.

For the pellicle film to have further improved strength and show even less variation in EUV transmissivity, the average of nearest-neighbor centroid-to-centroid distances between pores measured at a surface of the porous structure of the pellicle film is preferably, for example, in a range from 40 nm to 95 nm. The average of nearest-neighbor centroid-to-centroid distances may be 50 nm or more, or may be 55 nm or more. The average of nearest-neighbor centroid-to-centroid distances may be 80 nm or less, may be 68 nm or less, or may be 67 nm or less.

Regarding the pore characteristics measured at a surface of the porous structure of the pellicle film, the average of pore diameters and the coefficient of variation of pore diameters, and the average of nearest-neighbor centroid-to-centroid distances between pores and the coefficient of variation of nearest-neighbor centroid-to-centroid distances between pores may be measured by a method including the following steps (1) to (10). Since a unique threshold is determined by adopting the following measurement method, for example, plausible results are likely to be obtained irrespective of the measurer. The method of measuring the pore characteristics is, specifically, as described in Examples given later.

(1) A step of providing a pellicle film.
(2) A step of capturing an image of a surface of the provided pellicle film to acquire image data of the pellicle film.
(3) A step of setting a plurality of different thresholds of three or more as initial thresholds at equal intervals in a range from a first pixel value to a second pixel value larger than the first pixel value and performing binarization processing on the image data on the basis of each of the initial thresholds to acquire binarized image data based on the initial thresholds.

(4) A step of performing blob analysis on the binarized image data based on the initial thresholds to thereby obtain an initial actual value calculated as a distribution of pore characteristics of pores in the surface of the pellicle film.

(5) A step of determining, on the basis of the initial actual value, an initial theoretical value of the distribution of pore characteristics that is determined from a probability density function of a lognormal distribution.

(6) A step of determining a difference between the initial actual value and the initial theoretical value.

(7) A step, in the case where the difference between the initial actual value and the initial theoretical value is not minimal, of resetting a threshold, performing binarization processing on the image data on the basis of the reset threshold to acquire binarized image data based on the reset threshold, and performing blob analysis on the binarized image data based on the reset threshold to thereby obtain a remeasured actual value calculated as a distribution of pore characteristics of pores in the surface of the pellicle film.

(8) A step of determining, on the basis of the remeasured actual value, a difference from a remeasured theoretical value of the distribution of pore characteristics that is determined from a probability density function of a lognormal distribution.

(9) A step, in the case where the difference between the remeasured actual value and the remeasured theoretical value is not minimal, of repeating the step of obtaining a remeasured actual value and the step of determining a difference from a remeasured theoretical value until the difference between the remeasured actual value and the remeasured theoretical value becomes minimal.

(10) A step of obtaining, as a final actual value, a distribution of pore characteristics calculated on the basis of a threshold at which the difference between the initial actual value and the initial theoretical value or the difference between the remeasured actual value and the remeasured theoretical value is minimal.

The threshold at which the difference is minimal is preferably determined by using various known optimization algorithms. For example, it is preferable that a threshold at which the above-described difference is minimal is searched out using various known optimization algorithms in the above steps (4) to (9). In this case, after the initial thresholds are determined, the unique threshold is determined by using the optimization algorithms.

In the step of obtaining binarized image data based on the initial thresholds, the initial thresholds are not limited to those described above, and a plurality of different thresholds of five or more may be set at equal intervals in a range from a first pixel value to a second pixel value larger than the first pixel value, or a plurality of different thresholds of seven or more may be set. The interval between the first pixel value and the second pixel value is preferably 100 or more. The first pixel value is preferably set in a range from 20 to 50. The second pixel value is preferably set in a range from 150 to 240. Equal intervals mean that intervals between adjacent thresholds are equal: for example, when n thresholds are set as the plurality of different thresholds of three or more, the interval between the n-th threshold and the (n - 1)th threshold and the interval between the (n - 1)th threshold and the (n - 2)th threshold are equal. As the initial thresholds, specifically, for example, a plurality of different thresholds in a range from 3 to 12 can be set at equal intervals in a range from a pixel value of 20 to a pixel value of 240.

In the step of obtaining a remeasured actual value, the threshold to be reset is not the plurality of different thresholds of three or more but one threshold.

The pore characteristics may be measured with, for example, an apparatus including a program for causing a computer to execute the above steps (1) to (10). The program may be recorded on a recording medium.

The thickness of the pellicle film is preferably in a range from 3 nm to 1000 nm. The thickness of the pellicle film is preferably 10 nm or more, more preferably 20 nm or more. The thickness of the pellicle film is preferably 500 nm or less, more preferably 300 nm or less. When the thickness of the pellicle film is, for example, in a range from 3 nm to 1000 nm, the pellicle film tends to have further improved strength and to show even less variation in EUV transmissivity. In addition, the operability of the pellicle film improves.

The weight of the pellicle film per unit area is not particularly limited and is, for example, preferably in a range from $0.1 \ \mu g/cm^2$ to $20 \ \mu g/cm^2$. The weight of the pellicle film per unit area is more preferably $0.5 \ \mu g/cm^2$ or more, still more preferably $1 \ \mu g/cm^2$ or more. The weight of the pellicle film per unit area is more preferably $15 \ \mu g/cm^2$ or less, still more preferably $10 \ \mu g/cm^2$ or less. When the weight of the pellicle film per unit area is, for example, in a range from $0.1 \ \mu g/cm^2$ to $20 \ \mu g/cm^2$, the pellicle film tends to have further improved strength and to show even less variation in EUV transmissivity.

The pellicle film according to the exemplary embodiment is preferably a porous structural body formed by deposition of the carbon nanotubes. The porous structural body formed by deposition of the carbon nanotubes can be produced by an example of a preferred method for producing a pellicle film described later. When the pellicle film is a porous structural body formed by deposition of the carbon nanotubes, the pellicle film tends to have further improved strength and to show even less variation in EUV transmissivity.

From the viewpoint of improving transparency to exposure light, the pellicle film according to the exemplary embodiment preferably has a self-standing property. The pellicle film having a self-standing property means a pellicle film that is self-standing on its own and means that the pellicle film is a film having a self-supporting property (also referred to as a self-standing film). That is, the pellicle film having a self-standing property is a pellicle film that can retain its shape by itself even in the absence of a substrate or the like.

Method for Producing Pellicle Film

The method for producing a pellicle film is not particularly limited. An example of a preferred method for producing a pellicle film includes, for example, a step of dispersing carbon nanotubes (Step P1), a step of precipitating and depositing the dispersed carbon nanotubes on an air-permeable member to obtain a carbon nanotube film product formed in mat form on the air-permeable member (Step P2), and a step of removing the air-permeable member from the carbon nanotube film product to obtain a pellicle film (Step P3).

First, in Step P1, carbon nanotubes are dispersed in a liquid serving as a dispersion medium to prepare a carbon nanotube dispersion in which the carbon nanotubes are dispersed in the liquid. The liquid may be a liquid containing water. The carbon nanotube dispersion may contain only the carbon nanotubes as a dispersoid. The carbon nanotube dispersion may contain, in addition to the carbon nanotubes, various additives such as a dispersant for dispersing the carbon nanotubes.

For example, adjusting the balance between the dispersion intensity in dispersing the carbon nanotubes in the liquid in Step P1 and the weight of the carbon nanotubes per unit area in producing a carbon nanotube film product in Step P2 helps provide a pellicle film in which the coefficient of variation of pore diameters is 0.7 or less and the coefficient of variation of nearest-neighbor centroid-to-centroid distances between pores is 0.6 or less. For example, specifically, when the weight of the carbon nanotubes per unit area is a certain amount or more, the coefficient of variation of pore diameters is likely to satisfy the range of 0.7 or less, and when the weight of the carbon nanotubes per unit area is excessively reduced, the coefficient of variation of pore diameters tends to exceed 0.7. For example, when the dispersion intensity is kept within a certain range, the coefficient of variation of nearest-neighbor centroid-to-centroid distances between pores is likely to satisfy the range of 0.6 or less, and when the dispersion intensity is excessively increased, the coefficient of variation of nearest-neighbor centroid-to-centroid distances between pores tends to exceed 0.6.

Regarding the weight of the carbon nanotubes per unit area and the dispersion intensity, the amount of the carbon nanotubes contained in the carbon nanotube film product produced in Step P2 may be, for example, in a range from 0.1 $\mu$g/cm$^2$ to 20 $\mu$g/cm$^2$. Regarding the dispersion intensity, when a stirrer is used as a disperser for dispersing the carbon nanotubes, the peripheral speed of the stirrer may be, for example, in a range from 10 m/s to 60 m/s, and the duration of stirring with the stirrer may be, for example, in a range from 5 minutes to 60 minutes.

Next, in Step P2, the dispersed carbon nanotubes are precipitated and deposited on an air-permeable member. For example, the carbon nanotube dispersion prepared in Step P1 is filtered through a filtration membrane serving as an air-permeable member, so that the carbon nanotubes are precipitated and deposited to form a carbon nanotube film product formed in mat form on the filtration membrane. As the filtration membrane, for example, a membrane filter or the like is preferably used.

Next, in Step P3, the filtration membrane is removed from the carbon nanotube film product formed in mat form, whereby a pellicle film including carbon nanotubes is obtained. Before the filtration membrane is removed from the fiber film product formed in mat form, or after the filtration membrane is removed from the fiber film product formed in mat form, a drying step may be provided as necessary. The obtained pellicle film is a self-standing film.

Pellicle

A pellicle according to an exemplary embodiment includes the pellicle film according to the exemplary embodiment described above and a support that has a frame and an opening surrounded by the frame and that supports the pellicle film.

Hereinafter, the pellicle according to the exemplary embodiment will be described with reference to the drawings.

It should be noted that in drawings for description with reference to the drawings in this specification, some portions are illustrated in enlarged or reduced size for simplicity of explanation.

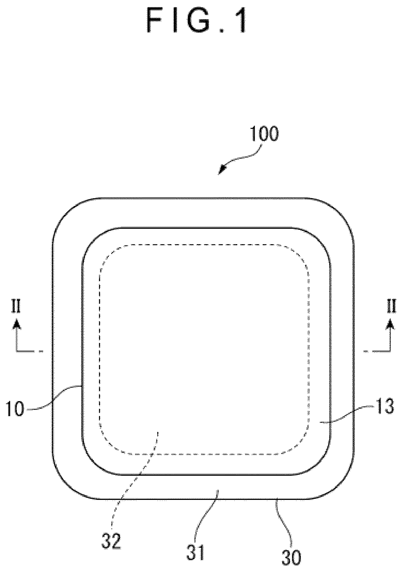

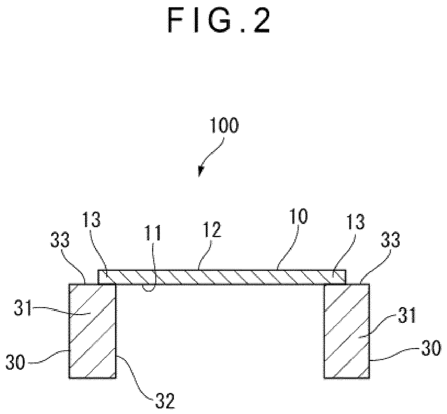

Fig. 1 is a plan view of a pellicle 100 as viewed in plan from a side on which a pellicle film 10 is disposed, and Fig. 2 is a sectional view of the pellicle 100 illustrated in Fig. 1. The pellicle 100 includes the pellicle film 10 and a support 30 that supports the pellicle film 10. The support 30 has a frame 31 and an opening 32 surrounded by the frame 31, and the opening 32 passes through the support 30 from one surface to the other surface. The frame 31 and the opening 32 are each formed in a rectangular shape, and all four corners of the outer contour of the frame 31 are rounded. The frame 31 has a support surface 33 that faces the pellicle film 10. The pellicle film 10 is formed in a rectangular shape and has a first pellicle film surface 11 that faces the support surface 33 of the support 30 and a second pellicle film surface 12 opposite to the first pellicle film surface 11. The pellicle film 10 covers the opening 32 of the support 30 such that a peripheral portion 13 of the pellicle film 10 is fixed to a portion of the support surface 33 of the frame 31.

The above-described pellicle film according to the exemplary embodiment is used as the pellicle film 10.

Examples of the material of the support 30 include resin materials (e.g., polyethylene), metal materials (e.g., aluminum, aluminum alloys, magnesium alloys, stainless steel, and titanium), ceramic materials (e.g., SiC), and fiber-reinforced plastic materials (e.g., carbon fiber-reinforced plastics).

For the pellicle film 10, to clarify the positional relationship between a surface facing the support surface 33 of the support 30 and the opposite surface, the terms "first pellicle film surface 11" and "second pellicle film surface 12" are used for convenience. Therefore, in some cases, the first pellicle film surface 11 and the second pellicle film surface 12 can be interchangeably used, and the first pellicle film surface 11 and the second pellicle film surface 12 can be used without distinction.

Although an example of the pellicle according to the exemplary embodiment has been described above with reference to Fig. 1 and Fig. 2, the pellicle according to the exemplary embodiment is not limited thereto. The pellicle according to the exemplary embodiment may employ any form as long as the advantageous effects of the pellicle including the above-described pellicle film according to the exemplary embodiment are obtained. The shape, dimensions, etc. of portions of members constituting the pellicle according to the exemplary embodiment can be determined according to, for example, the dimensions of a photomask (not illustrated) for which the pellicle according to the exemplary embodiment is used.

For example, the pellicle film 10 and the support 30 of the pellicle 100 illustrated in Fig. 1 and Fig. 2 are each formed in a rectangular shape.
The pellicle according to the exemplary embodiment is not limited thereto and may be formed in any desired shape such as a circular, elliptical, or polygonal shape.

For example, in the pellicle 100 illustrated in Fig. 1 and Fig. 2, the peripheral portion 13 of the pellicle film 10 is fixed to a portion of the support surface 33 of the support 30. The pellicle 100 is not limited thereto, and the peripheral portion 13 of the pellicle film 10 may be fixed to the entire surface of the support surface 33 of the support.

For example, in Fig. 1 and Fig. 2, the pellicle film 10 and the support 30 may be fixed together by providing a bonding layer (not illustrated). The bonding layer is a layer provided as necessary. Examples of materials constituting the bonding layer that may be used include, but are not limited to, various adhesives such as acrylic resins, epoxy resins, silicone resins, polyimide resins, and fluorocarbon resins, and carbon nanotubes.

Method for Producing Pellicle

An example of a preferred method for producing a pellicle according to an exemplary embodiment includes a step of preparing a pellicle film according to an exemplary embodiment, a step of preparing a support that has a frame and an opening surrounded by the frame and that supports the pellicle film, and a step of providing the pellicle film on the support such that the pellicle film covers the opening and is supported by a support surface of the frame. This production method may optionally include a step of providing a bonding layer on at least a portion of the support surface of the frame.

The step of preparing a pellicle film according to an exemplary embodiment only has to prepare the pellicle film according to the above exemplary embodiment. The step of preparing a support only has to prepare a support formed in a desired shape by a known method using any of the above-described materials for the support. The step of providing the pellicle film only has to dispose the pellicle film by a known method such that the pellicle film covers the opening and is supported by the support surface of the frame. When a bonding layer is provided on at least a portion of the support surface of the frame, the pellicle film is disposed so as to be supported by the support surface of the frame with the bonding layer therebetween. In the step of providing a bonding layer where an adhesive is used for the bonding layer, the adhesive is applied to the support surface to thereby provide the bonding layer including the adhesive. In the step of providing a bonding layer where carbon nanotubes are used for the bonding layer, for example, a carbon nanotube dispersion is applied to the support surface and dried to thereby provide the bonding layer including the carbon nanotubes.

The pellicle according to the exemplary embodiment is used, for example, while being disposed above a photomask so as to be spaced from the photomask such that the first pellicle film surface faces the photomask. Use of the pellicle according to the exemplary embodiment inhibits adhesion of foreign matter to the photomask and reduces variation in EUV transmissivity. In addition, since the pellicle film according to the exemplary embodiment has improved strength, breakage and the like during installation and transportation of the pellicle are inhibited.

The invention is not limited to the above exemplary embodiments and includes any modification, improvement, and the like as long as the object of the invention can be achieved.

Examples

The invention will now be described in more detail with reference to Examples, but these Examples are not intended to limit the invention.

Example 1

Preparation of Pellicle Film

As carbon nanotubes (hereinafter referred to as CNTs), CNTs having a diameter in a range from 0.2 nm to 50 nm and a length in a range from 1 µm to 250 µm were provided. The provided CNTs were weighed such that the concentration of the CNTs in a water dispersion would be 0.02 mass%. Carboxymethyl cellulose (hereinafter referred to as CMC) as a dispersant was weighed such that its concentration in the water dispersion would be 0.2 mass%. The weighed CNTs and the weighed CMC were put into water, and using a thin-film spin-system high-speed stirrer (manufactured by PRIMIX Corporation, product name "FILMIX"), the CNTs were dispersed in water at a peripheral speed of 40 m/s for a dispersion time of 10 minutes to prepare an aqueous CNT dispersion. The shear rate at which the CNTs were dispersed was about $4.0 \times 10^5$ s$^{-1}$. The aqueous CNT dispersion was then diluted to a CNT concentration of 1 ppm. The diluted aqueous CNT dispersion was then put into a filtration device such that the mass of the CNTs included in a pellicle film (denoted as Mass of CNT in film in Table 1) would be 0.88 µg/cm$^2$. The aqueous CNT dispersion put in the filtration device was then filtered through a membrane filter to form a CNT film product in mat form on the membrane filter. Thereafter, the CNT film product in mat form was peeled off from the membrane filter to prepare a pellicle film including the CNTs. The pellicle film was a film having a self-supporting property. On the basis of the pellicle film obtained, the coefficient of variation of pore diameters, the average of pore diameters, the coefficient of variation of nearest-neighbor centroid-to-centroid distances between pores, and the average of nearest-neighbor centroid-to-centroid distances between pores were calculated in accordance with Pore Analysis of Pellicle Film described below.

Pore Analysis of Pellicle Film

A surface of the pellicle film obtained in each Example was observed with a scanning electron microscope (SEM) (CrossBeam550 manufactured by Carl Zeiss) to acquire SEM image data. The imaging was performed at an acceleration voltage of 1 kV and a magnification of 10,000× in three or more fields of view.

On the basis of the SEM image data obtained, pore diameters (pore sizes) were analyzed as equivalent circle diameters. First, in one field of view of the SEM image data, seven initial binarization thresholds were set between a pixel value of 40 and a pixel value of 160 at equal intervals of 20 pixel values, i.e., at 40, 60, 80, 100, 120, 140, and 160, and seven binarized image data were obtained at these binarization thresholds. This operation was performed on the image data of the three or more fields of view.

Next, using the binarized image data obtained, the initial distribution of pore diameters based on the initial binarization thresholds was measured. Thereafter, fitting was performed using Bayesian optimization such that the actual value of the distribution of pore diameters closely approximated (fitted) the lognormal distribution, thereby automatically searching out binarization thresholds that minimized the difference between the actual value of the distribution of pore diameters and the theoretical value of the distribution of pore diameters. From the distribution of pore diameters and the distribution of nearest-neighbor centroid-to-centroid distances between pores measured on the basis of the binarization thresholds at which the difference between the actual value of the distribution of pore diameters and the theoretical value of the distribution of pore diameters was minimized, the coefficient of variation of pore diameters and the coefficient of variation of nearest-neighbor centroid-to-centroid distances between pores were calculated.

Strength Evaluation of Pellicle Film

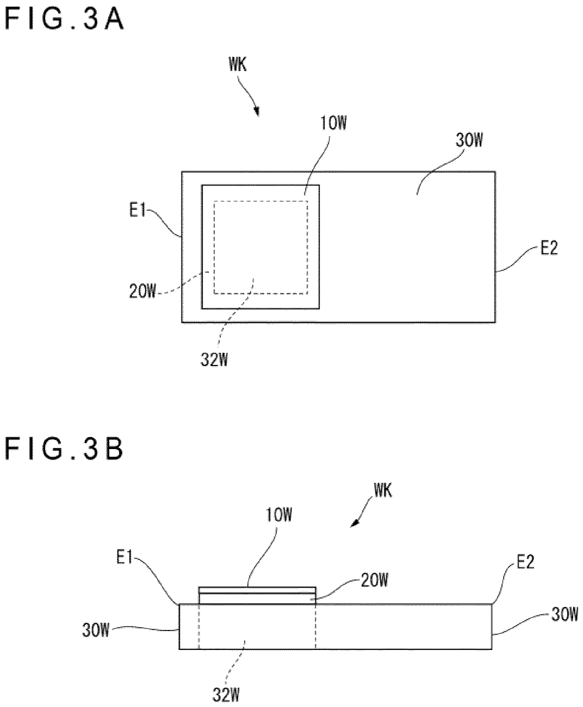

An acrylic plate having a size of 2 cm × 5 cm and a thickness of 2 mm was provided as a support. Near the center of one end of the acrylic plate, an opening surrounded in a frame shape and having a size of 1 cm × 1 cm was provided so as to pass through the acrylic plate. A portion extending from the outer periphery of the opening by 5 mm toward a region outside the opening was used as a support surface, and a double-sided adhesive tape was attached to the entire surface of the support surface. A peripheral portion of the pellicle film obtained in each Example was bonded and fixed onto the adhesive tape such that the opening was covered, thereby fabricating a pellicle for strength evaluation of a pellicle film (see Fig. 3A and Fig. 3B).

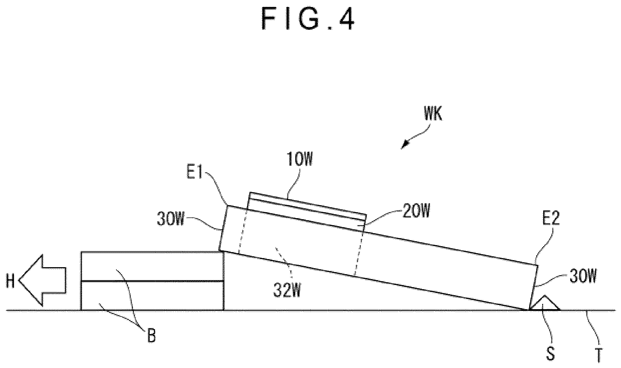

Here, the strength evaluation of a pellicle film will be described with reference to Fig. 3A, Fig. 3B, and Fig. 4. Fig. 3A is a schematic plan view of a pellicle WK for strength evaluation of a pellicle film (hereinafter referred to as a pellicle WK for strength evaluation) as viewed in plan from the pellicle film 10W side. Fig. 3B is a schematic side view of the pellicle WK for strength evaluation as viewed from the side along the longitudinal direction. The pellicle WK for strength evaluation is the pellicle for strength evaluation of a pellicle film fabricated above. The pellicle WK for strength evaluation is provided with an opening 32W passing through a support 30W on a first end E1 side of the support 30W. The double-sided adhesive tape as a bonding layer 20W is disposed in the region outside the outer periphery of the opening 32W. The pellicle film 10W is attached such that the bonding layer 20W is in contact with the peripheral portion of the pellicle film 10W. The pellicle film 10W is attached to the support 30W so as to cover the opening 32W with the bonding layer 20W interposed therebetween.

The evaluation was performed according to the following procedure. Fig. 4 schematically illustrates a method of evaluating the strength of a pellicle film using the pellicle WK for strength evaluation, and illustrates the pellicle WK for strength evaluation as viewed from the side along the longitudinal direction. As illustrated in Fig. 4, the pellicle WK for strength evaluation was first placed on a horizontal base T. A stopper S was disposed so as to be in contact with a second end E2 side of the pellicle WK for strength evaluation. Next, with the second end E2 side of the pellicle WK for strength evaluation being kept from slipping, the first end E1 side was lifted up, and a plate member B having a thickness of 1 mm was inserted between the base T and the pellicle WK for strength evaluation. Next, the plate member B was pulled out in a horizontal direction H so that the pellicle WK for strength evaluation fell down. After the pellicle WK for strength evaluation fell down, whether there was breakage of the pellicle film 10W was visually checked. When there was no breakage, another plate member B having a thickness of 1 mm was stacked up, and the two plate members B were inserted and pulled out in the horizontal direction H so that the pellicle WK for strength evaluation fell down. This operation was repeated until the pellicle film 10W suffered breakage, and a maximum height at which the pellicle film 10W did not suffer breakage was evaluated as the strength of the pellicle film 10W. The maximum height corresponds to the maximum number of stacked plate members B having a thickness of 1 mm. In the strength evaluation of the pellicle film 10W, the test according to the above procedure was performed three times, and the average of the three tests was employed.

Evaluation of Transmissivity at Wavelength of 550 nm

For the pellicle obtained in each Example, light transmittance at wavelengths from 200 nm to 800 nm was measured using an ultravioletvisible-near infrared spectrophotometer (manufactured by Shimadzu Corporation, product name "UV-VIS-NIR SPECTROPHOTOMETER UV-3600"), and the light transmittance (%) at a wavelength of 550 nm was extracted. For the measurement, an accessory large-sample compartment MPC-3100 was used, and the measurement was carried out without using a built-in integrating sphere. The light transmittance at a wavelength of 550 nm was measured at the centers of six pellicles fabricated under the same conditions, and their average was calculated.

Pellicle films including CNTs are known to have a correlation between their light transmittance at a wavelength of 13.5 nm and light transmittance at a wavelength of 550 nm (see, for example, Marina, Y, et al. "CNT EUV pellicle tunability and performance in a scanner-like environment,". Proc. SPIE 11609, Extreme Ultraviolet (EUV) Lithography XII, 116090Y, (23 March 2021). Figure 4(a).; doi: 10.1117/12.2584519)). Therefore, by evaluating the variation in the light transmittance at a wavelength of 550 nm, the variation in the light transmittance at a wavelength of 13.5 nm (i.e., the variation in EUV transmissivity) can be evaluated. If the light transmittance at a wavelength of 550 nm is 85% or more, for example, a high EUV transmittance (e.g., an EUV transmittance of 94% or more) is readily secured.

Example 2 to Example 7 and Comparative Example 1 to Comparative Example 4

Pellicle films were prepared in the same manner as in Example 1 except that the dispersion intensity and the mass of the CNTs included in the pellicle films (Mass of CNT in film) were changed as shown in Table 1, and the pore analysis of the pellicle films, the strength evaluation of the pellicle films, and the evaluation of transmissivity at a wavelength of 550 nm were performed.

[Table 1]

| | Mass of CNT in film | Dispersion intensity | | Pore diameter | | Nearest-neighbor centroid-to-centroid distance | | Strength evaluation | Evaluation of transmissivity at 550nm |
|---|---|---|---|---|---|---|---|---|---|
| | | Peripheral speed | Time | Coefficient of variation | Average | Coefficient of variation | Average | | |
| | ($\mu$g/cm$^2$) | (m/s) | (min) | (-) | (nm) | (-) | (nm) | (mm) | (%) |
| Example 1 | 0.88 | 40 | 10 | 0.547 | 47.5 | 0.308 | 58.1 | 14 | 85.9 |
| Example 2 | 0.88 | 40 | 15 | 0.534 | 41.4 | 0.334 | 58.2 | 16 | 85.1 |
| Example 3 | 0.79 | 40 | 20 | 0.570 | 39.8 | 0.413 | 64.5 | 16 | 85.7 |
| Example 4 | 0.71 | 40 | 10 | 0.652 | 55.1 | 0.296 | 58.8 | 11 | 89.9 |
| Example 5 | 0.53 | 40 | 25 | 0.666 | 49.1 | 0.381 | 66.1 | 15 | 87.8 |
| Example 6 | 1.1 | 30 | 30 | 0.412 | 36.1 | 0.586 | 66.9 | 20 | 85.0 |
| Example 7 | 1.8 | 30 | 30 | 0.471 | 35.5 | 0.468 | 66.3 | 25 | 85.0 |
| Comparative Example 1 | 0.44 | 40 | 10 | 0.707 | 74.8 | 0.304 | 74.7 | 7 | 92.2 |
| Comparative Example 2 | 0.53 | 40 | 10 | 0.746 | 72.1 | 0.328 | 72.9 | 7 | 89.3 |
| Comparative Example 3 | 0.35 | 40 | 25 | 0.825 | 90.8 | 0.392 | 85.9 | 4 | 89.9 |
| Comparative Example 4 | 0.88 | 40 | 25 | 0.446 | 33.2 | 0.667 | 89.0 | 8 | 82.9 |

The above results show that pellicle films in which the coefficient of variation of pore diameters is 0.7 or less and the coefficient of variation of nearest-neighbor centroid-to-centroid distances between pores is 0.6 or less are evaluated as excellent in strength of a pellicle film and transmissivity at a wavelength of 550 nm. Thus, according to an exemplary embodiment of the invention, a pellicle film having improved strength and showing less variation in EUV transmissivity and a pellicle including the pellicle film are provided.

EXPLANATION OF CODES

10, 10W...pellicle film, 11...first pellicle film surface, 12...second pellicle film surface, 13...peripheral portion, 20W...bonding layer, 30, 30W...support, 31...frame, 32, 32W...opening, 33...support surface, 100...pellicle, WK...pellicle for strength evaluation.

**Claims**

1.  A pellicle film having a porous structure,

    wherein the pellicle film comprises carbon nanotubes, and
    a coefficient of variation of pore diameters of pores is 0.7 or less, and a coefficient of variation of nearest-neighbor centroid-to-centroid distances between the pores is 0.6 or less, the coefficients of variation being measured at a surface of the porous structure.

2.  The pellicle film according to claim 1,
    wherein the coefficient of variation of pore diameters is in a range from 0.4 to 0.7.

3.  The pellicle film according to claim 1 or 2,
    wherein the coefficient of variation of nearest-neighbor centroid-to-centroid distances is in a range from 0.2 to 0.5.

4.  The pellicle film according to claim 1 or 2,
    wherein the carbon nanotubes have a length in a range from 0.1 $\mu$m to 1000 $\mu$m.

5.  The pellicle film according to claim 1 or 2,
    wherein the carbon nanotubes have a cross-sectional diameter in a range from 0.2 nm to 50 nm.

6.  The pellicle film according to claim 1 or 2,
    wherein an average of the pore diameters is in a range from 20 nm to 60 nm.

7.  The pellicle film according to claim 1 or 2,
    wherein the pellicle film is a porous structural body formed by deposition of the carbon nanotubes.

8.  The pellicle film according to claim 1 or 2,
    wherein the pellicle film has a self-standing property.

9.  A pellicle comprising:

    the pellicle film according to claim 1 or 2; and
    a support that has a frame and an opening surrounded by the frame and that supports the pellicle film.

# FIG.1

# FIG.2

FIG.3A

FIG.3B

FIG.4

## INTERNATIONAL SEARCH REPORT

| International application No. |
|---|
| **PCT/JP2024/011768** |

| A. | CLASSIFICATION OF SUBJECT MATTER |
|---|---|

*G03F 1/62*(2012.01)i
FI: G03F1/62

According to International Patent Classification (IPC) or to both national classification and IPC

| B. | FIELDS SEARCHED |
|---|---|

Minimum documentation searched (classification system followed by classification symbols)

G03F1/62

Documentation searched other than minimum documentation to the extent that such documents are included in the fields searched

Published examined utility model applications of Japan 1922-1996
Published unexamined utility model applications of Japan 1971-2024
Registered utility model specifications of Japan 1996-2024
Published registered utility model applications of Japan 1994-2024

Electronic data base consulted during the international search (name of data base and, where practicable, search terms used)

| C. | DOCUMENTS CONSIDERED TO BE RELEVANT |
|---|---|

| Category* | Citation of document, with indication, where appropriate, of the relevant passages | Relevant to claim No. |
|---|---|---|
| A | JP 2022-553694 A (LINTEC OF AMERICA, INC.) 26 December 2022 (2022-12-26) paragraphs [0029]-[0057], fig. 1-6 | 1-9 |
| A | JP 2022-534476 A (LINTEC OF AMERICA, INC.) 01 August 2022 (2022-08-01) claim 1, paragraphs [0028]-[0034], [0064], fig. 1-8 | 1-9 |
| A | WO 2022/060877 A1 (LINTEC OF AMERICA, INC.) 24 March 2022 (2022-03-24) claim 1, paragraphs [0073]-[0074], fig. 6 | 1-9 |
| A | JP 2018-194838 A (IMEC VZW) 06 December 2018 (2018-12-06) paragraphs [0051]-[0087], fig. 1-2 | 1-9 |
| A | WO 2014/142125 A1 (ASAHI KASEI E-MATERIALS CORP.) 18 September 2014 (2014-09-18) paragraphs [0037]-[0135], fig. 1-4 | 1-9 |

☐ Further documents are listed in the continuation of Box C.   ☑ See patent family annex.

| | |
|---|---|
| * Special categories of cited documents: | "T" later document published after the international filing date or priority date and not in conflict with the application but cited to understand the principle or theory underlying the invention |
| "A" document defining the general state of the art which is not considered to be of particular relevance | |
| "D" document cited by the applicant in the international application | "X" document of particular relevance; the claimed invention cannot be considered novel or cannot be considered to involve an inventive step when the document is taken alone |
| "E" earlier application or patent but published on or after the international filing date | |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search | Date of mailing of the international search report |
|---|---|
| **14 May 2024** | **28 May 2024** |

| Name and mailing address of the ISA/JP | Authorized officer |
|---|---|
| **Japan Patent Office (ISA/JP)** **3-4-3 Kasumigaseki, Chiyoda-ku, Tokyo 100-8915 Japan** | |
| | Telephone No. |

Form PCT/ISA/210 (second sheet) (July 2022)

## INTERNATIONAL SEARCH REPORT
### Information on patent family members

International application No.

**PCT/JP2024/011768**

| Patent document cited in search report | | | Publication date (day/month/year) | Patent family member(s) | | | Publication date (day/month/year) |
|---|---|---|---|---|---|---|---|
| JP | 2022-553694 | A | 26 December 2022 | US | 2022/0363543 | A1 | |
| | | | | claim 1, paragraphs [0038]-[0066], fig. 1-6 | | | |
| | | | | WO | 2021/081361 | A1 | |
| | | | | TW | 202130409 | A | |
| JP | 2022-534476 | A | 01 August 2022 | US | 2022/0144641 | A1 | |
| | | | | claim 1, paragraphs [0038]-[0044], [0074], fig. 1-8 | | | |
| | | | | WO | 2020/243112 | A1 | |
| | | | | TW | 202106617 | A | |
| | | | | KR | 10-2022-0016026 | A | |
| WO | 2022/060877 | A1 | 24 March 2022 | US | 2023/095318 | A1 | |
| | | | | claim 1, paragraphs [0074]-[0075], fig. 6 | | | |
| | | | | TW | 202219654 | A | |
| | | | | KR | 10-2023-0023007 | A | |
| | | | | CN | 115943346 | A | |
| JP | 2018-194838 | A | 06 December 2018 | US | 2018/0329291 | A1 | |
| | | | | paragraphs [0054]-[0090], fig. 1-2 | | | |
| | | | | EP | 3404486 | A1 | |
| | | | | CN | 108878259 | A | |
| WO | 2014/142125 | A1 | 18 September 2014 | CN | 105051604 | A | |
| | | | | KR | 10-2015-0119148 | A | |
| | | | | | | A | |
| | | | | TW | 201441757 | A | |

Form PCT/ISA/210 (patent family annex) (July 2022)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- WO 2021172104 A